# EUROPEAN PATENT APPLICATION

(11) **EP 2 854 163 A1**
(43) Date of publication of application: **01.04.2015**
(21) Application number: 14187002.2
(22) Date of filing: 30.09.2014
(51) Int. Cl.: H01L 21/67

(54) **Substrate processing device and substrate processing method**

(30) Priority: 30.09.2013 JP 2013205285; 15.07.2014 JP 2014145265
(71) Applicant: Shibaura Mechatronics Corporation, Yokohama-shi Kanagawa (JP)
(72) Inventor: Nagashima, Yuji, Kanagawa (JP); Matsushita, Jun, Kanagawa (JP); Hayashi, Konosuke, Kanagawa (JP); Miyazaki, Kunihiro, Kanagawa (JP); Furuya, Masaaki, Kanagawa (JP); Azumano, Hidehito, Kanagawa (JP); Tauchi, Toyoyasu, Kanagawa (JP)
(74) Representative: Twelmeier Mommer & Partner

(57) **Abstract**

A substrate processing device 100 includes a solvent replacing unit (organic solvent supply unit 15 and solvent supply unit 34) replacing a cleaning liquid with a volatile solvent of a low concentration, and thereafter further performing replacement with a volatile solvent of a high concentration.

## Description

The disclosure of Japanese Patent Application No. 2013-205285 filed September 30, 2013 and Japanese Patent Application No. 2014-145265 filed July 15, 2014 including specifications, drawings and claims is incorporated herein by reference in its entirety.

### [Field of the Invention]

The present intention relates to a substrate processing device and a substrate processing method.

### [Related Art]

In manufacturing semiconductors and others, a substrate processing device supplies a processing liquid to a surface of a substrate of a wafer, a liquid crystal substrate or the like to process a surface of the substrate, then supplies a cleaning liquid such as ultrapure water to the substrate surface to clean the substrate surface, and further dries it. In the drying, there are problems that occur with patterns, e.g., around memory cells and gates collapses due to miniaturization according to increase in integration degree and capacity of the semiconductors in recent years. This is due to spacing between patterns, structures of them, a surface tension of the cleaning liquid and others. During the substrate drying, since the patterns are mutually pulled by a surface tension of a cleaning liquid that remains between the patterns, the patterns elastically deform and fall so that the pattern collapse occurs.

Accordingly, for the purpose of suppressing the pattern collapsing, such a substrate drying method has been proposed (e.g., see JP 2008-34779 A (Patent Literature 1)) that uses IPA (2-Propanol: Isopropyl Alcohol) having a smaller surface tension than the ultrapure water, and mass production factories and others have employed a method of drying the substrate by replacing the ultrapure water on the substrate surface with the IPA.

A substrate processing device disclosed in JP 2008-34779 A (Patent Literature 1) is provided with a cleaning liquid supply unit for supplying a cleaning liquid to the surface of the substrate, and a solvent supply unit that supplies a volatile solvent to the surface of the substrate supplied with the cleaning liquid to replace the cleaning liquid on the surface of the substrate with the volatile solvent.

[Patent Literature 1] Japanese Patent Application Publication No. 2008-34779

### [Summary of the Invention]

### [Problems to be Solved by the Invention]

However, the solvent supply unit of the substrate processing device disclosed in JP 2008-34779 A (Patent Literature 1) supplies the volatile solvent of a concentration of a single value to the surface of the substrate only one time, and efficiency of replacing the cleaning liquid with the volatile solvent is low.

When the cleaning liquid supplied to the surface of the substrate is not sufficiently replaced with the volatile solvent such as IPA having a lower surface tension, the pattern collapse at the time of the substrate drying cannot be prevented effectively. This pattern collapse becomes more remarkable with miniaturization of the semiconductor.

An object of the invention is to prevent effectively the pattern collapse during the substrate drying by reliably replacing the cleaning liquid on the substrate surface with the volatile solvent.

### [Means for Solving the Problems]

According to the present invention, there is provided a substrate processing device for supplying a cleaning liquid to a surface of a substrate, replacing the cleaning liquid with a volatile solvent, and heating the surface of the substrate to remove the volatile solvent and to dry the surface of the substrate, including:
a solvent replacing unit replacing the cleaning liquid with a volatile solvent of a low concentration, and thereafter performing replacement with a volatile solvent of a high concentration.

According to the present invention, there is provided a substrate processing method for supplying a cleaning liquid to a surface of a substrate, replacing the cleaning liquid with a volatile solvent, and heating the surface of the substrate to remove the volatile solvent and to dry the surface of the substrate, including:
a solvent replacing step of replacing the cleaning liquid with a volatile solvent of a low concentration, and thereafter performing replacement with a volatile solvent of a high concentration.

### [Effect of the Invention]

The substrate processing device and the substrate processing method of the invention can reliably replace the cleaning liquid on the substrate surface with the volatile solvent, and can effectively prevent the pattern collapse at the time of the substrate drying.

### [BRIEF DESCRIPTION OF DRAWINGS]

FIG. 1 is a schematic view illustrating a substrate processing device of an embodiment 1;
FIG. 2 is a schematic view illustrating a cleaning chamber;
FIG. 3 is a schematic view illustrating a solvent replacing chamber;
FIG. 4 is a schematic view illustrating a substrate processing device of an embodiment 2;
FIG. 5 is a schematic view illustrating a solvent replacing chamber, a transfer unit, and a drying chamber;
FIGS. 6A and 6B are schematic views illustrating a drying state of a volatile solvent on a substrate surface; and
FIG. 7 is a schematic view illustrating a substrate processing chamber of an embodiment 3.

### [DETAILED DESCRIPTION]

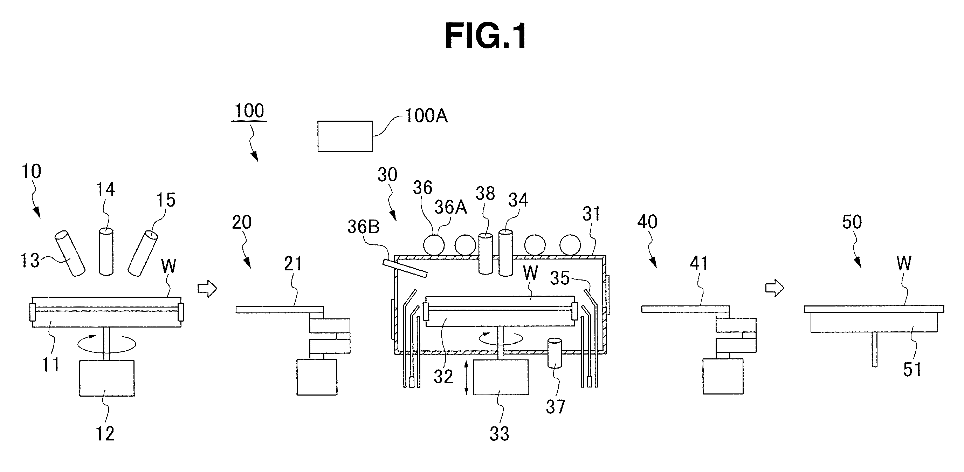

### (Embodiment 1) (FIGS. 1 to 3)

A substrate processing device 100 of an embodiment 1 includes, as illustrated in FIG. 1, a cleaning chamber 10, a transfer unit 20, a solvent replacing chamber 30, a transfer unit 40, and a cooling unit 50, and the cleaning chamber 10 is independent of the solvent replacing chamber 30.

Accordingly, the substrate processing device 100 supplies a cleaning liquid to a surface of a substrate W such as a wafer or a liquid crystal substrate in the cleaning chamber 10, and transfers the substrate W by the transfer unit 20 from the cleaning chamber 10 to the solvent replacing chamber 30. In the solvent replacing chamber 30, the substrate processing device 100 replaces the cleaning liquid on the surface of the substrate W with a volatile solvent, and removes the volatile solvent by heating the surface of the substrate W to dry the surface of the substrate W. Further, it transfers the substrate W by the transfer unit 40 from the solvent replacing chamber 30 to the cooling unit 50, and naturally or forcedly cools the substrate W.

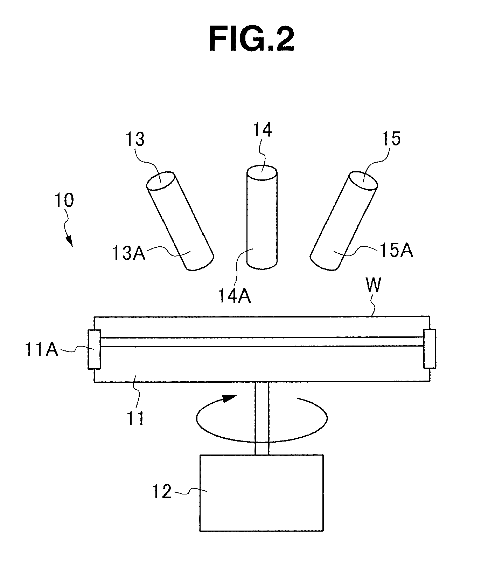

In a processing box (not illustrated) closed with respect to an outside, of the cleaning chamber 10 includes, as illustrated in FIG. 2, a table 11 horizontally supporting the substrate W and a rotation mechanism 12 horizontally rotating the table 11. The table 11 includes support members 11A such as pins removably supporting the substrate W. The rotation mechanism 12 rotates the table 11 by a motor or the like.

The cleaning chamber 10 includes a chemical solution supply unit 13, a cleaning liquid supply unit 14, and an organic solvent supply unit 15, and successively supplies a chemical solution, a cleaning liquid (e.g., pure water or ozone water), and an organic solvent to the surface of the rotating substrate W.

The chemical solution supply unit 13 has a nozzle 13A supplying a chemical solution such as APM (liquid mixture of ammonia solution and hydrogen peroxide solution) for removing organic substance to the surface of the substrate W on the table 11.

The cleaning liquid supply unit 14 includes a nozzle 14A supplying a cleaning liquid such as pure water (ultrapure water) for the cleaning processing to the surface of the substrate W on the table 11. The cleaning liquid cleans the surface of the substrate W by washing away the chemical solution supplied from the chemical solution supply unit 13.

The organic solvent supply unit 15 includes a nozzle 15A supplying an organic solvent to the surface of the substrate W on the table 11. The organic solvent may be alcohols (low boiling point solvent) such as IPA or methanol), or high boiling point solvent such as ether, ethylene carbonate, or dimethyl sulfoxide which can be dissolved in or mixed into the water, i.e., the cleaning liquid supplied by the cleaning liquid supply unit 14. The organic solvent supply unit 15 replaces the cleaning liquid such as water supplied to the surface of the substrate W from the cleaning liquid supply unit 14 with the organic solvent.

When volatile organic solvent such as IPA is used as the organic solvent supplied by the organic solvent supply unit 15, this organic solvent is used in a state of an aqueous solution of a low concentration, e.g., of 50% or lower for preventing drying of the surface of the substrate W during transference of the substrate W from the cleaning chamber 10 to the solvent replacing chamber 30 by the transfer unit 20. The concentration of the solvent is a volume percentage of the solvent component in the aqueous solution prepared by mixing the solvent into pure water, (and the same shall apply hereafter). When the organic solvent supplied from the organic solvent supply unit 15 is a high boiling solvent, it hardly volatilizes so that the aqueous solution concentration is not restricted.

That is, the organic solvent supply unit 15 forms a low-concentration solvent replacing unit that replaces the cleaning liquid on the surface of the substrate W with the low-concentration volatile solvent (organic solvent).

The transfer unit 20 operates to transfer, by a robot 21, the substrate W of which surface was supplied with the cleaning liquid and the organic solvent in the cleaning chamber 10, and is wet with the mixture of the cleaning liquid and the organic solvent to the solvent replacing chamber 30.

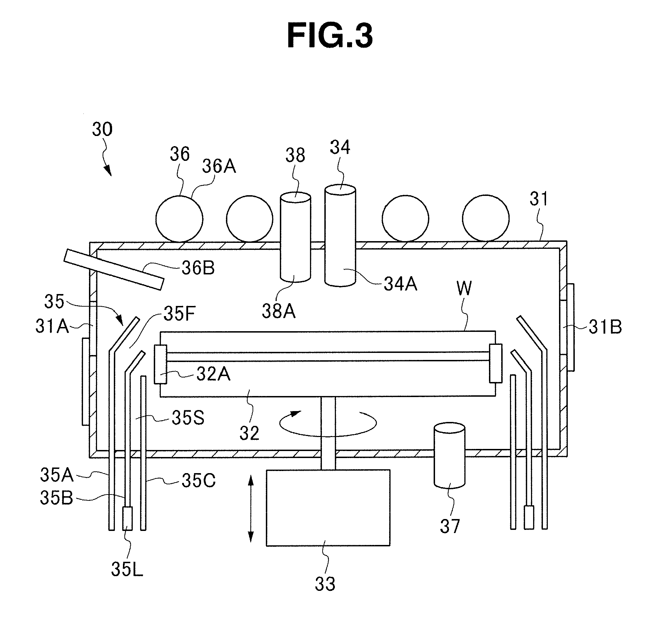

In a processing box 31 closed with respect to the outside, as illustrated in FIG. 3, the solvent replacing chamber 30 has a table 32 horizontally carrying the substrate W, and a rotation mechanism 33 horizontally rotating the table 32. The table 32 includes support members 32A such as pins removably holding the substrate W. The processing box 31 has an open/close shutter for a substrate transfer inlet 31A that is a transfer inlet for the substrate W transferred from the cleaning chamber 10, and also has an open/close shutter for a substrate transfer outlet 31B for transferring the substrate W processed in the processing box 31 to the cooling unit 50. The rotation mechanism 33 rotates the table 32 by a motor or the like.

The solvent replacing chamber 30 has a solvent supply unit 34, includes a nozzle 34A supplying the volatile solvent to the surface of the substrate W supplied with the cleaning liquid and the organic solvent in the cleaning chamber 10, and replaces the cleaning liquid and the organic solvent on the surface of the substrate W with the volatile solvent. The volatile solvent may be alcohols such as IPA or methanol, ether, ketone or the like of a high concentration, e.g., of 100% which can be dissolved or mixed into the water, i.e., the cleaning liquid supplied by the cleaning liquid supply unit 14, or can be dissolved or mixed into the organic solvent supplied by the organic solvent supply unit 15 of the cleaning chamber 10. The cleaning liquid and the organic solvent supplied to the surface of the substrate W from the cleaning liquid supply unit 14 and the organic solvent supply unit 15 in the cleaning chamber 10 are replaced by the solvent supply unit 34 with the volatile solvent.

That is, the solvent supply unit 34 forms a high-concentration solvent replacing unit which replaces the cleaning liquid and the organic solvent of the low concentration on the surface of the substrate W with the volatile solvent of the high concentration.

The solvent replacing chamber 30 has a discharged liquid collection cup 35 located in the processing box 31 and surrounding the table 32. The discharged liquid collection cup 35 has annular walls 35A, 35B and 35C that are concentrically arranged around the table 32. An annular space between the annular walls 35A and 35B is a first collection portion 35F, and an annular space between the annular walls 35B and 35C is a second collection portion 35S.

When the solvent supply unit 34 starts the supply of the volatile solvent in an initial stage of a solvent replacing step, and an elevator 35L positions the annular wall 35B of the discharged liquid collection cup 35 at the lowering end, the first collection portion 35F opens wide around the substrate W on the table 32, and collects the cleaning liquid, the organic solvent, and the volatile solvent which are spun off and removed from the surface of the rotating substrate W.

When the elevator 35L positions the annular wall 35B of the discharged liquid collection cup 35 at the rising end after the initial stage ends in the solvent replacing step of supplying the volatile solvent from the solvent supply unit 34, the second collection portion 35S opens wide around the substrate W on the table 32, and collects the volatile solvent of a high concentration which is spun off and removed from the surface of the rotating substrate W. At this time, the opening of the first collection portion 35F is opened only slightly or closed to promote the replacement of the cleaning liquid and the organic solvent with the volatile solvent on the surface of the substrate W without returning the collected cleaning liquid and organic solvent toward the substrate W.

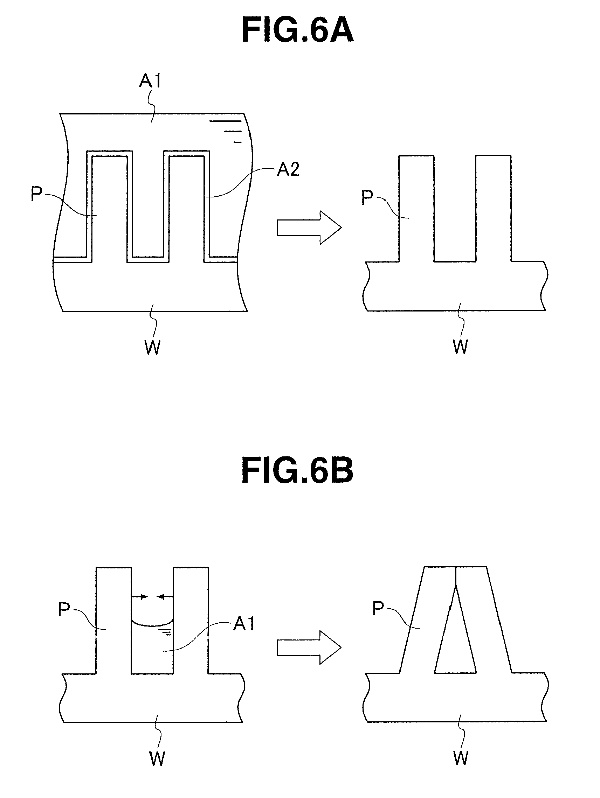

The solvent replacing chamber 30 has a drying unit 36 that heats and dries the surface of the substrate W covered with the substituted volatile solvent. The drying unit 36 has lamps 36A such as halogen lamps which are located above the table 32 and serve as a heating unit acting through an infrared-transparent quartz window or the like, although the heating unit may be a hot plate or the like. The lamps 36A heat the surface of the substrate W to a temperature above the temperature of the volatile solvent. Owing to the heating operation of the lamps 36A, as illustrated in FIG. 6A, a liquid A1 of the volatile solvent in contact with the pattern P on the surface of the substrate W starts to vaporize prior to the liquid A1 of the volatile solvent on the other portions. In other words, in the liquid A1 of the volatile solvent supplied to the surface of the substrate W, only the portion in contact with the surface of the substrate W is rapidly heated to attain a vapor phase. Thereby, around the patterns P on the surface of the substrate W, a layer of a gas (collection of bubbles), i.e., a gas layer A2 of the volatile solvent taking a form of a thin film is formed as a result of vaporization (boiling) of the liquid A1 of the volatile solvent. Therefore, the liquid A1 of the volatile solvent between the neighboring patterns P is pushed by the gas layer A2 onto the surface of the substrate W, and changes into many liquid droplets owing to its surface tension. FIG. 6B illustrates a phenomenon in which the various portions of the substrate surface are dried at uneven speeds during the drying of the liquid, so that the liquid A1 remains between some patterns P and the surface tension of the remaining liquid A1 collapses the pattern.

The drying unit 36 includes a blow-off gas supply nozzle 36B located inside the processing box 31 and above the table 32 for blowing and removing the liquid droplets of the volatile solvent produced on the surface of the substrate W by an injection hot gas made of an inert gas such as a nitrogen gas. A gas discharging pipe 37 connected to a vacuum pump, a gas discharging fan or the like opens at a floor of the processing box 31, and externally discharges by suction the liquid droplets of the volatile solvent removed from the surface of the substrate W as described above. The drying unit 36 may include a suction slit (not illustrated) for removing by suction the liquid droplets of the volatile solvent in addition to the blow-off gas supply nozzle 36B.

The solvent replacing chamber 30 has a low-humidity gas atmosphere forming unit 38. The gas atmosphere forming unit 38 includes a nozzle 38A supplying a low-humidity gas into the processing box 31. The low-humidity gas may be a dry air or the like, and promotes drying of the surface of the substrate W in the processing box 31. An inert gas of nitrogen or the like may be employed as the low-humidity gas for preventing production of water marks on the surface of the substrate W and ensuring explosion proof against the high-concentration volatile solvent. The gas such as water vapor and others in the processing box 31 that is purged by this low-humidity gas is externally discharged through the gas discharging pipe 37.

The transfer unit 40 transfers, by a robot 41, the substrate W dried in the solvent replacing chamber 30 to the cooling unit 50.

The cooling unit 50 cools the hot substrate W transferred onto a table 51 from the solvent replacing chamber 30 to or below a predetermined temperature such as a room temperature by natural or forced cooling. The cooled substrate W is stored in a substrate storing cassette or the like, and is discharged from the substrate processing device 100.

The procedures of cleaning and drying the substrate W by the substrate processing device 100 will now be described below. The substrate processing device 100 has a controller 100A. The controller 100A has a microcomputer performing integrated control of various portions, and a storage storing substrate processing information and various programs relating to the substrate processing. The controller 100A controls, based on the substrate processing information and the various programs, the various portions of the cleaning chamber 10, the transfer unit 20, the solvent replacing chamber 30, the transfer unit 40, and the cooling unit 50 as described in the following (1) to (7).

(1) After the substrate W is set on the table 11 in the cleaning chamber 10, the table 11 rotates at a predetermined rotation speed, and then the chemical solution, i.e., APM discharged from the nozzle 13A of the chemical solution supply unit 13 is supplied to the center of the surface of the substrate W for a predetermined time. The centrifugal force caused by the rotation of the substrate W spreads the chemical solution throughout the surface of the substrate W.

(2) After the chemical solution supply unit 13 stops the supply of the chemical solution, the cleaning liquid, i.e., pure water discharged from the nozzle 14A of the cleaning liquid supply unit 14 is supplied to the center of the surface of the substrate W for a predetermined time. The centrifugal force caused by rotation of the substrate W spreads the cleaning liquid throughout the surface of the substrate W so that the chemical solution already supplied is washed away.

(3) After the cleaning liquid supply unit 14 stops the supply of the cleaning liquid, the organic solvent, i.e., the low-concentration IPA discharged from the nozzle 15A of the organic solvent supply unit 15 is supplied to the center of the surface of the substrate W for a predetermined time. The centrifugal force caused by the rotation of the substrate W spreads the low-concentration IPA throughout the surface of the substrate W, and the cleaning liquid already supplied is replaced with the low-concentration IPA.

(4) In the cleaning chamber 10, the table 11 stops the rotation, the organic solvent supply unit 15 stops the supply of the organic solvent, i.e., the low-concentration IPA, and the cleaning of the substrate W on the table 11 is completed. Thereby, the cleaned surface of the substrate W attains the state in which the liquid of the low-concentration IPA or the cleaning liquid mixed with the low-concentration IPA forms a liquid film on the surface. Then, the robot 21 of the transfer unit 20 takes out the cleaned substrate W in the above state on the table 11, transfers the substrate W into the processing box 31 of the solvent replacing chamber 30, and sets it on the table 32. Thereafter, the nozzle 38A of the gas atmosphere forming unit 38 supplies a low-humidity gas such as a dry air or an inert gas of nitrogen or the like into the processing box 31.

(5) In the state where the substrate W is set on the table 32 in the solvent replacing chamber 30, the table 32 rotates at a predetermined rotation speed, and then the volatile solvent, i.e., the high-concentration IPA discharged from the nozzle 34A of the solvent supply unit 34 is supplied to the center of the substrate W for a predetermined time. The centrifugal force caused by the rotation of the substrate W spreads the volatile solvent throughout the surface of the substrate W, and the cleaning liquid and the organic solvent remaining on the surface of the substrate W are replaced with the volatile solvent. That is, on the surface of the substrate W, the low-concentration IPAor the cleaning liquid mixed with the low-concentration IPA is replaced with the high-concentration IPA.

In the above operation, the rotation speed of the table 32 and thus the substrate W is set to form a thin film of the volatile solvent on the surface of the substrate W without exposing the surface of the substrate W. The IPA discharged from the nozzle 34A of the solvent supply unit 34 is set to a temperature lower than its boiling point so that the IPA kept reliably in the liquid state is supplied to the surface of the substrate W. Thereby, the ultrapure water and the organic solvent are reliably and uniformly replaced with the IPA throughout the surface of the substrate W.

(6) After the solvent supply unit 34 stops the supply of the IPA, the lamps 36A of the drying unit 36 are turned on to heat the substrate W on the rotating table 32 for a predetermined time. This instantaneously vaporizes the liquid A1 of the volatile solvent in contact with the pattern P on the surface of the substrate W, and can immediately change the volatile solvent A1 on the other portions of the surface of the substrate W into liquid droplets.

In the heating operation by the lamps 36A of the drying unit 36, it is important to heat the substrate W to a high temperature of hundreds of degrees C within several seconds for instantaneously vaporizing the IPA, i.e., the volatile solvent in contact with the pattern P of the substrate W. Also, it is necessary to heat only the substrate W without heating the IPA. For this, it is desired to employ the lamps 36A having a peak intensity between 500 and 3000 nm in wavelength. For the reliable drying, it is desired that the final temperature of the substrate W (i.e., the final temperature attained by the heating) is higher by 20°C or more than the boiling points of the processing liquid and the solvent under the atmospheric pressure. Additionally, it is desired that the time reaching the final temperature is in a range not exceeding 10 seconds and, for example, between several tens of milliseconds and several seconds.

The liquid droplets of the IPA produced on the surface of the substrate W by the heating operation of the lamps 36A of the drying unit 36 are dispersed radially outward by the centrifugal force caused by the rotation of the substrate W, and are also dispersed radially outward by the hot gas injected from the blow-off gas supply nozzle 36B. The removed droplets of the IPA are drawn and discharged through the gas discharging pipe 37 opening at the floor of the processing box 31. Thereby, the surface drying of the substrate W ends.

(7) When the table 32 stops the rotation in the solvent replacing chamber 30, and the lamps 36A are turned off, the robot 41 of the transfer unit 40 takes out the substrate W dried on the table 32, and sets this hot substrate W in the cooling unit 50. The substrate W is naturally or forcedly cooled in the cooling unit 50.

The embodiment achieves the following operations and effects.

(A) The organic solvent supply unit 15 serving as the low-concentration solvent replacing unit and the solvent supply unit 34 serving as the high-concentration solvent replacing unit are arranged, and the cleaning liquid supplied to the surface of the substrate W is replaced with the volatile solvent of a low concentration, which is then replaced with the volatile solvent of a high concentration. Therefore, the cleaning liquid can be efficiently replaced within a short time.

The reason of the above (A) is as follows:
Since the volatile solvent (e.g., the IPA) has a smaller surface tension than pure water, it can easily enter even the spaces between the patterns of a high aspect ratio.

However, the IPA cannot be easily mixed with the pure water. Therefore, when the IPA of 100% in concentration is applied to the substrate of which cleaning with the pure water is completed, these are mixed together at a vicinity of a boundary between the IPA and the pure water. However, in the state where the pure water is present between the patterns, it is very difficult to locate the IPA between the patterns. This may cause the pattern collapse and the water marks already described.

Contrarily, such a case will be discussed below that, to the substrate already cleaned with the pure water, the liquid mixture of the pure water and the IPA having the IPA concentration of 20% is supplied for a predetermined time, then the liquid mixture of the pure water and the IPA having the IPA concentration of 50% is supplied for a predetermined time, thereafter the liquid having the IPA concentration of 70% is further supplied for a predetermined time, and finally the liquid having the IPA concentration of 100% is supplied for a predetermined time.

Since the liquid mixture of the pure water and the IPA having the IPA concentration of 20% has a composition close to that of the pure water existing at the substrate surface, these are mixed easily. When the liquid mixture of the pure water and the IPA having the IPA concentration of 50% is to be supplied, the liquid on the substrate is already changed by replacement from the pure water into the liquid mixture of the pure water and the IPA having the IPA concentration of 20%. Since the liquid mixture of the pure water and the IPA having the IPA concentration of 50% has a composition close to that of the liquid mixture of the pure water and the IPA having the IPA concentration of 20%, these are mixed easily. When the liquid having the IPA concentration of 70% is to be supplied, the liquid on the substrate is already the liquid mixture of the pure water and the IPA having the IPA concentration of 50%. Since the liquid having the IPA concentration of 70% has a composition close to that of the liquid mixture of the pure water and the IPA having the IPA concentration of 50%, these are mixed easily. When the liquid having the IPA concentration of 100% is to be supplied, the liquid on the substrate is already the liquid mixture of the pure water and the IPA having the IPA concentration of 70%. Since the liquid having the IPA concentration of 100% has a composition close to that of the liquid mixture of the pure water and the IPA having the IPA concentration of 70%, these are mixed easily.

For the above reason, as compared with a manner of applying a liquid having an IPA concentration of 100% to the pure water from the start, the successive changes from the lower concentration to the higher concentration can spread the IPA between the patterns, and allow reliable replacement of the cleaning liquid.

(B) The low-concentration solvent replacing unit (the organic solvent supply unit 15) and the high-concentration solvent replacing unit (the solvent supply unit 34) are arranged in the different processing chambers, i.e., the cleaning chamber 10 and the solvent replacing chamber 30, respectively. When the substrate W is taken out from the cleaning chamber 10, and is transferred to the solvent replacing chamber 30, the surface of the substrate W is already covered with a liquid film of the IPA of the concentration (50% or lower in this embodiment) lower than the final concentration (100% in this embodiment) of the volatile solvent used for the drying processing, or with a liquid film of the cleaning liquid mixed with the low-concentration IPA. Therefore, during the transfer of the substrate W from the cleaning chamber 10 to the solvent replacing chamber 30, drying of the surface of the substrate W can be prevented, and formation of the water marks due to the surface drying of the substrate W can be suppressed.

The embodiment also offers the following operations.

(a) The cleaning chamber 10 for supplying the cleaning liquid and the organic solvent to the surface of the substrate W is independent of the solvent replacing chamber 30 for supplying the volatile solvent to the surface of the substrate W already supplied with the cleaning liquid and the organic solvent, and thereby replacing the cleaning liquid and the organic solvent on the surface of the substrate W with the volatile solvent. Therefore, the solvent replacing chamber 30 is not provided with any supply system for the cleaning liquid, and there is no possibility that the cleaning liquid (e.g., ultrapure water) adheres to the inside of the solvent replacing chamber or water vapor thereof floats therein. Accordingly, when the volatile solvent is supplied to the surface of the substrate W in the solvent replacing chamber 30 to replace the cleaning liquid and the organic solvent already supplied to the surface of the substrate in the cleaning chamber 10 with the volatile solvent, such unnecessary water, water vapor and the like are not adsorbed to the volatile solvent, and are not newly adhered to the surface of the substrate W so that the replacement thereof can be promoted. Thereby, the cleaning liquid and the organic solvent existing between the patterns of the substrate W can be rapidly

replaced with the volatile solvent having a low surface tension, and the pattern collapse during the drying of the substrate W can be effectively prevented.

(b) Since the cleaning liquid and the organic solvent on the surface of the substrate W can be rapidly replaced with the volatile solvent as described above, this can reduce the consumption amount of the volatile solvent, and can improve the productivity of the substrates W.

(c) The heating of the substrate W by the drying unit 36 arranged in the solvent replacing chamber 30 rapidly vaporizes the IPA that is the substituted volatile solvent and is located around the patterns on the surface of the substrate W, and a thin film of a gas layer of the vaporized IPA is formed around the patterns P. Thereby, the liquid of the IPA between the neighboring patterns of the substrate W is pushed out by the gas layer, and changes into many liquid droplets owing to its own surface tension. The liquid droplets of the IPA produced on the surface of the substrate W are dispersed radially outward by the centrifugal force caused by the rotation of the substrate W, and are immediately removed (although the blow-off gas supply nozzle 36B or a suction slit forming the drying unit 36 may be additionally used). Therefore, the liquid of the IPA can be instantaneously dried throughout the surface of the substrate W, the IPA does not remain between the patterns, and the pattern collapse due to the surface tension of the remaining IPA can be suppressed.

(d) Since the solvent replacing chamber 30 has the low humidity gas atmosphere forming unit 38, a low humidity can be kept in the space around the surface of the substrate W to promote the drying of the surface of the substrate W in the above (c), and the drying time of the drying unit 36 can be reduced.

(e) Since the low-humidity gas atmosphere forming unit 38 supplies the inert gas of nitrogen or the like, the space around the surface of the substrate W can be covered with the inert gas atmosphere to lower the oxygen concentration on the surface of the substrate W so that the generation of water marks can be prevented. Since the inert gas atmosphere covers the space around the surface of the substrate W supplied with the volatile solvent, the safety relating to explosion proof against the volatile solvent can be ensured.

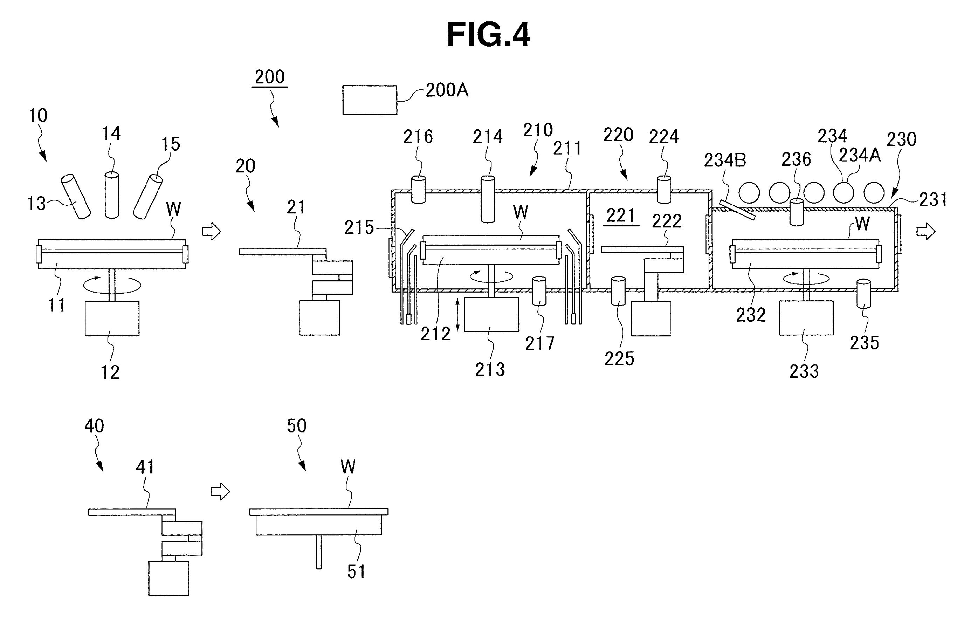

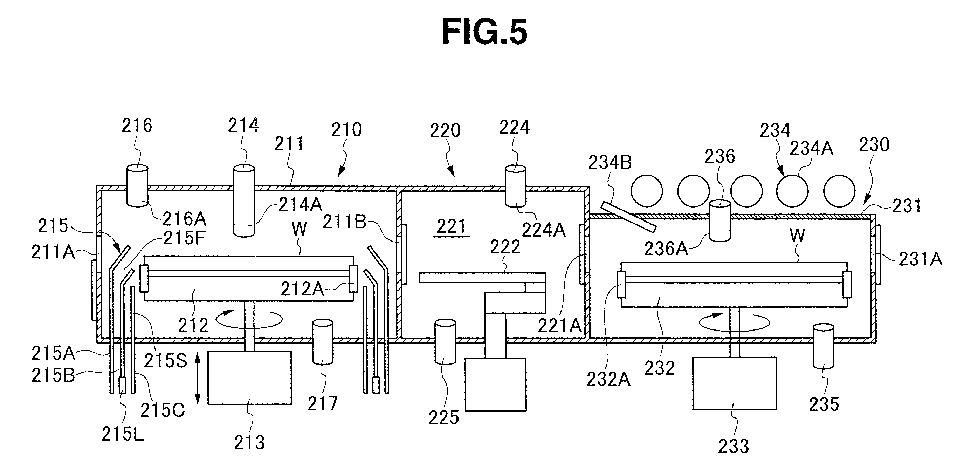

### (Embodiment 2) (FIGS. 4 and 5)

A substrate processing device 200 of an embodiment 2 differs from the substrate processing device 100 of the embodiment 1 in that the solvent replacing chamber 30 provided with the drying unit 36 is replaced with a solvent replacing chamber 210, a transfer unit 220 and a drying chamber 230 which are arranged in series as illustrated in FIGS. 4 and 5, a cleaning chamber 10 and the solvent replacing chamber 210 are independent of each other, and further the solvent replacing chamber 210 and the drying chamber 230 are independent of each other.

Accordingly, in the substrate processing device 200, a cleaning liquid and an organic solvent are supplied to a surface of a substrate W such as a wafer, a liquid crystal substrate or the like in the cleaning chamber 10, a transfer unit 20 transfers the substrate W from the cleaning chamber 10 to the solvent replacing chamber 210, the cleaning liquid and the organic solvent on the surface of the substrate W are replaced with a volatile solvent in the solvent replacing chamber 210, the transfer unit 220 transfers the substrate W to the drying chamber 230, and the surface of the substrate W is heated in the drying chamber 230 to remove the volatile solvent and dry the surface of the substrate W. Further, a transfer unit 40 transfers the substrate W from the drying chamber 230 to a cooling unit 50, and the substrate W is naturally or forcedly cooled.

In the substrate processing device 200, the cleaning chamber 10, the transfer units 20 and 40, and the cooling unit 50 are the same as those in the substrate processing device 100.

In a processing box 211 closed with respect to the outside, as illustrated in FIG. 5, the solvent replacing chamber 210 has a table 212 horizontally supporting the substrate W, and a rotation mechanism 213 horizontally rotating the table 212. The table 212 includes support members 212A such as pins removably holding the substrate W. The processing box 211 has an open/close shutter for a substrate transfer inlet 211A that is a transfer inlet for the substrate W transferred from the cleaning chamber 10, and also has an open/close shutter for a substrate transfer outlet 211B for transferring the substrate W processed in the processing box 211 to the transfer unit 220. The rotation mechanism 213 rotates the table 212 by a motor or the like.

The solvent replacing chamber 210 has a solvent supply unit 214, includes a nozzle 214A supplying the volatile solvent to the surface of the substrate W supplied with the cleaning liquid and the organic solvent in the cleaning chamber 10, and replaces the cleaning liquid and the organic solvent on the surface of the substrate W with the volatile solvent. The volatile solvent may be alcohols such as IPA or methanol, ether, ketone or the like of a high concentration, e.g., of 100% which can be dissolved or mixed into the water, i.e., the cleaning liquid supplied by the cleaning liquid supply unit 14 of the cleaning chamber 10, or can be dissolved or mixed into the organic solvent supplied by the organic solvent supply unit 15 of the cleaning chamber 10. The cleaning liquid and the organic solvent supplied to the surface of the substrate W from the cleaning liquid supply unit 14 and the organic solvent supply unit 15 in the cleaning chamber 10 are replaced by the solvent supply unit 214 with the volatile solvent.

That is, the solvent supply unit 214 forms a high-concentration solvent replacing unit which replaces the cleaning liquid and the organic solvent of the low concentration on the surface of the substrate W with the volatile solvent of the high concentration.

The solvent replacing chamber 210 has a discharged liquid collection cup 215 located in the processing box 211 and surrounding the table 212. The discharged liquid collection cup 215 has annular walls 215A, 215B and 215C that are concentrically arranged around the table 212. An annular space between the annular walls 215A and 215B is a first collection portion 215F, and an annular space between the annular walls 215B and 215C is a second collection portion 215S.

When the solvent supply unit 214 starts the supply of the volatile solvent in an initial stage of a solvent replacing step, and an elevator 215L positions the annular wall 215B of the discharged liquid collection cup 215 at the lowering end, the first collection portion 215F opens wide around the substrate W on the table 212, and collects the cleaning liquid, the organic solvent, and the volatile solvent which are spun off and removed from the surface of the rotating substrate W.

When the elevator 215L positions the annular wall 215B of the discharged liquid collection cup 215 at the rising end after the initial stage ends in the solvent replacing step of supplying the volatile solvent from the solvent supply unit 214, the second collection portion 215S opens wide around the substrate W on the table 212, and collects the volatile solvent of a high concentration which is spun off and removed from the surface of the rotating substrate W. At this time, the opening of the first collection portion 215F is opened only slightly or closed to promote the replacement of the cleaning liquid and the organic solvent with the volatile solvent on the surface of the substrate W without returning the collected cleaning liquid and organic solvent toward the substrate W.

The solvent replacing chamber 210 has a low humidity gas atmosphere forming unit 216. The gas atmosphere forming unit 216 includes a nozzle 216A supplying the low-humidity gas into a processing box 211. As the low-humidity gas, a dry air or the like is employed for promoting the replacement of the cleaning liquid and the organic solvent on the surface of the substrate W with the volatile solvent in the processing box 211. As the low-humidity gas, an inert gas of nitrogen or the like may be employed for preventing production of water marks on the surface of the substrate W and achieving explosion proof against the high-concentration volatile solvent. The gas such as water vapor in the processing box 211 purged by the low-humidity gas is drawn by suction into a gas discharging pipe 217 opening at the floor of the processing box 211 and is externally discharged. The gas discharging pipe 217 is connected to a vacuum pump, a gas discharging fan and the like.

The transfer unit 220 has a robot 222 arranged in a transfer chamber 221 that is closed with respect to the outside. The transfer chamber 221 includes an open/close shutter at a substrate transfer outlet 221A for transferring the substrate W to the drying chamber 230.

The transfer chamber 221 has a low humidity gas atmosphere forming unit 224. The gas atmosphere forming unit 224 includes a nozzle 224A supplying a low-humidity gas into the transfer chamber 221. The low-humidity gas is, e.g., a dry air. An inert gas of nitrogen or the like may be employed for preventing production of water marks on the surface of the substrate W and achieving explosion proof against the high-concentration volatile solvent. The gas of the volatile solvent in the transfer chamber 221 purged by the low-humidity gas is drawn by suction into a gas discharging pipe 225 opening at the floor of the transfer chamber 221 and is externally discharged. The gas discharging pipe 225 is connected to a vacuum pump, a discharging fan and the like.

By the robot 222, the transfer unit 220 transfers the substrate W of which liquid on the surface was replaced with the volatile solvent in the solvent replacing chamber 210 to the drying chamber 230. The transfer unit 220 opens the substrate transfer outlet 211B of the solvent replacing chamber 210 only when it transfers the substrate W from the solvent replacing chamber 210 into the transfer chamber 221, and opens the substrate transfer outlet 221A only when it transfers the substrate W from the transfer chamber 221 into the drying chamber 230. The substrate W passes through the transfer chamber 221 having the low-humidity gas atmosphere formed by the gas atmosphere forming unit 224, and is transferred from the solvent replacing chamber 210 to the drying chamber 230.

In a processing box 231 closed with respect to the outside, as illustrated in FIG. 5, the drying chamber 230 has a table 232 horizontally supporting the substrate W, and a rotation mechanism 233 horizontally rotating the table 232. The table 232 includes support members 232A such as pins removably holding the substrate W. The processing box 231 includes an open/close shutter in a substrate transfer outlet 231A for transferring the substrate W to the cooling unit 50. The rotation mechanism 233 rotates the table 232 by a motor or the like.

The solvent replacing chamber 230 has a drying unit 234 that heats and dries the surface of the substrate W covered with the substituted volatile solvent in the solvent replacing chamber 210. The drying unit 234 has lamps 234A such as halogen lamps which are located above the table 232 and serve as a heating unit acting through an infrared-transparent quartz window or the like, although the heating unit may be a hot plate or the like. The lamps 234A heat the surface of the substrate W to a temperature above the temperature of the volatile solvent. Owing to the heating operation of the lamps 234A, as illustrated in FIG. 6A, a liquid A1 of the volatile solvent in contact with the pattern P on the surface of the substrate W starts to vaporize prior to the liquid A1 of the volatile solvent on the other portions. In other words, in the liquid A1 of the volatile solvent supplied to the surface of the substrate W, only the portion in contact with the surface of the substrate W is rapidly heated to attain a vapor phase. Thereby, around the patterns P on the surface of the substrate W, a layer of a gas (collection of bubbles), i.e., a gas layer A2 of the volatile solvent taking a form of a thin film is formed as a result of vaporization (boiling) of the liquid A1 of the volatile solvent. Therefore, the liquid A1 of the volatile solvent between the neighboring patterns P is pushed by the gas layer A2 onto the surface of the substrate W, and changes into many liquid droplets owing to its surface tension. FIG. 6B illustrates a phenomenon in which the various portions of the substrate surface are dried at uneven speeds during the drying of the liquid, so that the liquid A1 remains between some patterns P and the surface tension of the remaining liquid A1 collapses the pattern.

The drying unit 234 includes a blow-off gas supply nozzle 234B located inside the processing box 231 and above the table 232 for blowing and removing the liquid droplets of the volatile solvent produced on the surface of the substrate W by an injection hot gas made of an inert gas such as a nitrogen gas. A gas discharging pipe 235 connected to a vacuum pump, a gas discharging fan or the like opens at a floor of the processing box 231, and externally discharges by suction the liquid droplets of the volatile solvent removed from the surface of the substrate W as described above. The drying unit 234 may include a suction slit (not illustrated) for removing by suction the liquid droplets of the volatile solvent in addition to the blow-off gas supply nozzle 234B.

The drying chamber 230 has a low humidity gas atmosphere forming unit 236. The gas atmosphere forming unit 236 includes a nozzle 236A supplying a low-humidity gas into the processing box 231. The low-humidity gas is a dry air or the like for promoting drying of the surface of the substrate W in the processing box 231. As the low-humidity gas, an inert gas of nitrogen or the like may be employed for preventing production of water marks on the surface of the substrate W and achieving explosion proof against the high-concentration volatile solvent.

The procedures of cleaning and drying the substrate W by the substrate processing device 200 will now be described below. The substrate processing device 200 has a controller 200A. The controller 200A has a microcomputer performing integrated control of various portions, and a storage storing substrate processing information and various programs relating to the substrate processing. The controller 200A controls, based on the substrate processing information and various programs, the various portions of the cleaning chamber 10, the transfer unit 20, the solvent replacing chamber 210, the transfer unit 220, the drying chamber 230, the transfer unit 40, and the cooling unit 50 as described in the following (1) to (8).

(1) After the substrate W is set on the table 11 in the cleaning chamber 10, the table 11 rotates at a predetermined rotation speed, and then the chemical solution, i.e., APM discharged from the nozzle 13A of the chemical solution supply unit 13 is supplied to the center of the surface of the substrate W for a predetermined time. The centrifugal force caused by the rotation of the substrate W spreads the chemical solution throughout the surface of the substrate W.

(2) After the chemical solution supply unit 13 stops the supply of the chemical solution, the cleaning liquid, i.e., pure water discharged from the nozzle 14A of the cleaning liquid supply unit 14 is supplied to the center of the surface of the substrate W for a predetermined time. The centrifugal force caused by rotation of the substrate W spreads the cleaning liquid throughout the surface of the substrate W so that the chemical solution already supplied is washed away.

(3) After the cleaning liquid supply unit 14 stops the supply of the cleaning liquid, the organic solvent, i.e., the low-concentration IPA discharged from the nozzle 15A of the organic solvent supply unit 15 is supplied to the center of the surface of the substrate W for a predetermined time. The centrifugal force caused by the rotation of the substrate W spreads the low-concentration IPA throughout the surface of the substrate W, and the cleaning liquid already supplied is replaced with the low-concentration IPA.

(4) In the cleaning chamber 10, the table 11 stops the rotation, the organic solvent supply unit 15 stops the supply of the organic solvent, i.e., the low-concentration IPA, and the cleaning of the substrate W on the table 11 is completed. Thereby, the cleaned surface of the substrate W attains the state in which the liquid of the low-concentration IPA or the cleaning liquid mixed with the low-concentration IPA forms a liquid film on the surface. Then, the robot 21 of the transfer unit 20 takes out the cleaned substrate W in the above state on the table 11, transfers the substrate W into the processing box 211 of the solvent replacing chamber 210, and sets it on the table 212. Thereafter, the nozzle 216A of the gas atmosphere forming unit 216 supplies a low-humidity gas such as a dry air or an inert gas of nitrogen or the like into the processing box 211.

(5) In the state where the substrate W is set on the table 212 in the solvent replacing chamber 210, the table 212 rotates at a predetermined rotation speed, and then the volatile solvent, i.e., the high-concentration IPA discharged from the nozzle 214A of the solvent supply unit 214 is supplied to the center of the substrate W for a predetermined time. The centrifugal force caused by the rotation of the substrate W spreads the volatile solvent throughout the surface of the substrate W, and the cleaning liquid and the organic solvent remaining on the surface of the substrate W are replaced with the volatile solvent. That is, on the surface of the substrate W, the low-concentration IPA or the cleaning liquid mixed with the low-concentration IPA is replaced with the high-concentration IPA.

In the above operation, the rotation speed of the table 212 and thus the substrate W is set to form a thin film of the volatile solvent on the surface of the substrate W without exposing the surface of the substrate W. The IPA discharged from the nozzle 214A of the solvent supply unit 214 is set to a temperature lower than its boiling point so that the IPA kept reliably in the liquid state is supplied to the surface of the substrate W. Thereby, the ultrapure water and the organic solvent are reliably and uniformly replaced with the IPA throughout the surface of the substrate W.

(6) In the solvent replacing chamber 210, when the table 212 stops its rotation, and the solvent supply unit 214 stops supply of the IPA, the robot 222 of the transfer unit 220 takes out the substrate W which is located on the table 212 and covered with the substituted volatile solvent, transfers it into the processing box 231 of the drying chamber 230 through the transfer chamber 221 having the low-humidity gas atmosphere formed by the gas atmosphere forming unit 224, and sets the substrate W on the table 232. Thereafter, the nozzle 236A of the gas atmosphere forming unit 236 supplies the low-humidity gas such as a dry air or an inert gas of nitrogen or the like into the processing box 231.

(7) In the state where the substrate W is set on the table 232 in the drying chamber 230, the table 232 rotates at a predetermined rotation speed, and then the lamps 234A of the drying unit 234 are turned on to heat the substrate W on the rotating table 232 for a predetermined time. This instantaneously vaporizes the liquid A1 of the volatile solvent in contact with the pattern P on the surface of the substrate W, and can immediately change the volatile solvent A1 on the other portions of the surface of the substrate W into liquid droplets.

In the heating operation by the lamps 231A of the drying unit 234, it is important to heat the substrate W to a high temperature of hundreds of degrees C within several seconds for instantaneously vaporizing the IPA, i.e., the volatile solvent in contact with the pattern P of the substrate W. Also, it is necessary to heat only the substrate W without heating the IPA. For this, it is desired to employ the lamps 234A having a peak intensity between 500 and 3000 nm in wavelength. For the reliable drying, it is desired that the final temperature of the substrate W (i.e., the final temperature attained by the heating) is higher by 20°C or more than the boiling points of the processing liquid and the solvent under the atmospheric pressure. Additionally, it is desired that the time reaching the final temperature is in a range not exceeding 10 seconds and, for example, between several tens of milliseconds and several seconds.

The liquid droplets of the IPA produced on the surface of the substrate W by the heating operation of the lamps 234A of the drying unit 234 are dispersed radially outward by the centrifugal force caused by the rotation of the substrate W, and are also dispersed radially outward by the hot gas injected from the blow-off gas supply nozzle 234B. The removed droplets of the IPA are drawn and discharged through the gas discharging pipe 235 opening at the floor of the processing box 231. Thereby, the surface drying of the substrate W ends.

(8) When the table 232 stops the rotation in the drying chamber 230 and the lamps 234A are turned off, a robot 41 of the transfer unit 40 takes out the substrate W dried on the table 232, and sets this hot substrate W in the cooling unit 50. The substrate W is naturally or forcedly cooled in the cooling unit 50.

The embodiment achieves the following operations and effects in addition to those in the foregoing (A), (B), (a) and (b) of the embodiment 1. However, the solvent supply unit 34 serving as the high-concentration solvent replacing unit and the solvent replacing chamber 30 in the foregoing (A) and (B) are replaced with the solvent supply unit 214 and the solvent replacing chamber 210, respectively.

(i) In the solvent replacing chamber 210, the low-humidity gas atmosphere forming unit 216 supplies the inert gas of nitrogen or the like so that the inert gas atmosphere covers a space around the surface of the substrate W to reduce the oxygen concentration on the surface of the substrate W, and the production of the water marks can be prevented. Since the inert gas atmosphere covers the space around the surface of the substrate W supplied with the volatile solvent, the safety relating to explosion proof against the volatile solvent can be ensured.

(ii) The transfer unit 220 transferring the substrate W from the solvent replacing chamber 210 to the drying chamber 230 has the low-humidity gas atmosphere forming unit 224. By transferring the substrate W while covering, with the inert gas atmosphere, the space around the surface of the substrate W covered with the substituted volatile solvent, even the substrate supplied with the high-concentration volatile solvent can be prevented from drying during the transference so that the safety relating to the explosion proof can be improved. Also, the substrate W can be transferred while suppressing the production of the water marks by reducing the oxygen concentration around the substrate.

(iii) By heating the substrate W in the drying chamber 230, the IPA liquid can be instantaneously dried throughout the surface of the substrate W, and the pattern collapse due to the surface tension of the remaining IPA can be suppressed.

The drying chamber 230 is independent of the solvent replacing chamber 210, and is not provided with any supply system for the volatile solvent. Therefore, any volatile solvent is not brought into the drying chamber 230 except for that brought thereinto by the substrate W from the solvent replacing chamber 210 so that the safety relating to the explosion proof can be high.

(iv) Owing to the provision of the gas atmosphere forming unit 236 in the drying chamber 230, the low humidity can be attained in the space around the surface of the substrate W to promote the drying of the surface of the substrate W so that the drying time of the drying unit 234 can be reduced.

Since the low-humidity gas atmosphere forming unit 236 supplies the inert gas of nitrogen or the like, the space around the surface of the substrate W can be covered with the inert gas atmosphere to reduce the oxygen concentration on the surface of the substrate W so that the production of the water mark can be prevented. Since the inert gas atmosphere covers the space around the surface of the substrate W supplied with the volatile solvent, the safety relating to the explosion proof against the volatile solvent can be ensured.

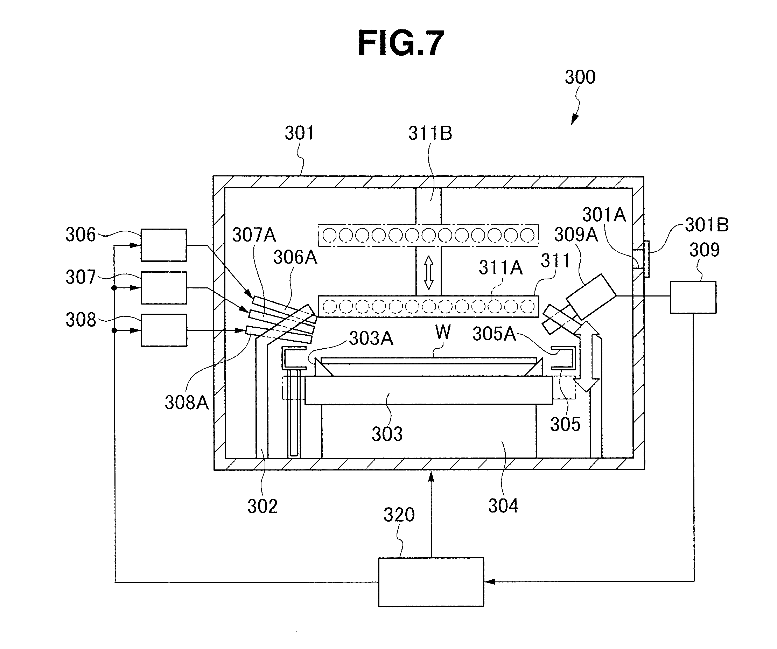

### (Embodiment 3) (FIG. 7)

An embodiment 3 employs a substrate processing chamber 300 formed by integrating the cleaning chamber 10 and the solvent replacing chamber 30 in the substrate processing device 100 of the embodiment 1.

The substrate processing chamber 300 includes, as illustrated in FIG. 7, a processing box 301 serving as a processing chamber, a cup 302 arranged in the processing box 301, a table 303 horizontally supporting the substrate W in the cup 302, a rotation mechanism 304 horizontally rotating the table 303, and a solvent suction discharging unit 305 that is vertically movable around the table 303. Further, the substrate processing chamber 300 includes a chemical solution supply unit 306 supplying a chemical solution to the surface of the substrate W on the table 303, a cleaning liquid supply unit 307 supplying a cleaning liquid to the surface of the substrate W on the table 303, a solvent supply unit 308 supplying the volatile solvent, a gas supply unit 309 supplying a gas, a heating unit 311 heating the substrate W supplied with the volatile solvent, and a controller 320 controlling various portions.

The processing box 301 has a substrate inlet/outlet 301A opening in a portion of its peripheral wall. The substrate inlet/outlet 301A can be opened and closed by a shutter 301B.

The cup 302 has a cylindrical form, surrounds a periphery of the table 303 and accommodates it. The peripheral wall of the cup 302 is tapered to converge obliquely upward, and opens to expose upwardly the substrate W on the table 303. The cup 302 receives the chemical solution and the cleaning liquid that flow down or are dispersed from the rotating substrate W. At the bottom of the cup 302, a discharging pipe (not illustrated) is arranged for discharging the received chemical solution and cleaning liquid.

The table 303 is positioned near a center of the cup 302, and can rotate horizontally. The table 303 has a plurality of support members 303A such as pins, which removably holds the substrate W such as a wafer or a liquid crystal substrate.

The rotation mechanism 304 has a rotation shaft coupled to the table 303 and a motor serving as a drive source rotating the rotation shaft (although both are not illustrated). The motor rotates the table 303 through the rotation shaft. The rotation mechanism 304 is electrically connected to the controller 320, which controls the drive thereof.

The solvent suction discharging unit 305 includes a solvent suction port 305A having an annular opening surrounding the periphery of the table 303. The solvent suction discharging unit 305 has an elevating mechanism (not illustrated) for raising and lowering the solvent suction port 305A to a standby position in which the solvent suction port 305A is positioned lower than the table surface of the table 303 and an operation position in which the solvent suction port 305A is positioned around the substrate W held on the table 303. The solvent suction port 305A receives by suction the volatile solvent dispersed from the rotating substrate W. The solvent suction port 305A is connected to a discharging fan or a vacuum pump (not illustrated) for drawing in the volatile solvent, as well as a discharging pipe (not illustrated) for discharging the drawn and received volatile solvent.

The chemical solution supply unit 306 has a nozzle 306A discharging the chemical solution obliquely to the surface of the substrate W on the table 303, and the nozzle 306A supplies through this nozzle 306A the chemical solution such as APM (mixture of ammonia solution and hydrogen peroxide solution) for resist peeling processing to the surface of the substrate W on the table 303. The nozzle 306A is attached to an upper portion of the peripheral wall of the cup 302, and an angle, a discharging flow speed and the like are adjusted to supply the chemical solution to a central portion of the substrate W. The chemical solution supply unit 306 is electrically connected to the controller 320, which controls the drive thereof. The chemical solution supply unit 306 includes a tank for storing the chemical solution, a pump serving as a drive source, a valve serving as a regulator valve for regulating a supply rate, and others, although these are not illustrated.

The cleaning liquid supply unit 307 has a nozzle 307A discharging the cleaning liquid obliquely to the surface of the substrate W on the table 303, and the nozzle 307A supplies the cleaning liquid such as pure water (ultrapure water) for the cleaning processing to the surface of the substrate W on the table 303. The nozzle 307A is attached to an upper portion of the peripheral wall of the cup 302, and an angle, a discharging flow speed and the like are adjusted to supply the cleaning liquid to the central portion of the surface of the substrate W. The cleaning liquid supply unit 307 is electrically connected to the controller 320, which controls the drive thereof. The cleaning liquid supply unit 307 includes a tank for storing the cleaning liquid, a pump serving as a drive source, a valve serving as a regulator valve for regulating a supply rate, and others, although these are not illustrated.

The solvent supply unit 308 has a nozzle 308A discharging the volatile solvent obliquely to the surface of the substrate W on the table 303, and the nozzle 308A supplies the volatile solvent such as IPA to the surface of the substrate W on the table 303. The solvent supply unit 308 supplies the volatile solvent to the surface of the substrate W cleaned with the cleaning liquid supplied from the cleaning liquid supply unit 307, and replaces the cleaning liquid on the surface of the substrate W with the volatile solvent. The nozzle 308A is attached to an upper portion of the peripheral wall of the cup 302, and an angle, a discharging flow speed and the like are adjusted to supply the volatile solvent to the central portion of the surface of the substrate W. The solvent supply unit 308 is electrically connected to the controller 320, which controls the drive thereof. The solvent supply unit 308 includes a tank for storing the volatile solvent, a pump serving as a drive source, a valve serving as a regulator valve for regulating a supply rate, and others, although these are not illustrated.

The gas supply unit 309 has a nozzle 309A discharging a gas obliquely to the surface of the substrate W on the table 303, and the nozzle 309A supplies the gas such as a nitrogen gas to the surface of the substrate W on the table 303, and forms a nitrogen gas atmosphere in the space on the surface of the substrate W in the processing box 301. The nozzle 309A is attached to an upper portion of the peripheral wall of the cup 302, and an angle, a discharging flow speed and the like are adjusted to supply the gas to the central portion of the surface of the substrate W. The gas supply unit 309 is electrically connected to the controller 320, which controls the drive thereof. The gas supply unit 309 includes a tank for storing the gas, a valve serving as a regulator valve for regulating a supply rate, and others, although these are not illustrated.

The heating unit 311 has a plurality of lamps 311A, is arranged above the table 303, and irradiates the surface of the substrate W on the table 303 with the light by turning on each lamp 311A. The heating unit 311 can be vertically moved (in the elevating direction) by a moving mechanism 311B between an irradiation position close the cup 302 (i.e., a position close to the surface of the substrate W as indicated by solid line in FIG. 7) and a standby position spaced from the cup 302 by a predetermined distance (i.e., a position spaced from the surface of the substrate W as indicated by alternate long and short dash line in FIG. 7). This heating unit 311 is electrically connected to the controller 320, which controls the drive thereof. Similarly to the drying unit 36 in the substrate processing device 100, the heating unit 311 instantaneously vaporizes a liquid A1 of the volatile solvent in contact with the pattern P on the surface of the substrate W, and immediately changes the liquid A1 of the volatile solvent on the other portions of the surface of the substrate W into liquid droplets. The liquid droplets of the IPA produced on the surface of the substrate W by the heating operation of the heating unit 311 are dispersed radially outward by the centrifugal force caused by the rotation of the substrate W, and are drawn and removed into the solvent suction port 305A of the solvent suction discharging unit 305.

Particularly, in the embodiment, the solvent supply unit 308 forms a solvent replacing unit which replaces the cleaning liquid supplied to the surface of the substrate W by the cleaning liquid supply unit 307 with the low-concentration volatile solvent, and further performs the replacement with the high-concentration volatile solvent.

In the embodiment, the solvent replacing unit (solvent supply unit 308) is arranged in the single processing box 301, the solvent supply unit 308 first discharges from the nozzle 308A the low-concentration volatile solvent in the state of the aqueous solution of 50% or lower in concentration to replace the cleaning liquid on the surface of the substrate W with it, and thereafter further discharges the high-concentration volatile solvent in the state of the aqueous solution of 100% or the like in concentration to replace the cleaning liquid and the low-concentration volatile solvent on the surface of the substrate W with it. Thereby, the cleaning liquid supplied to the surface of the substrate W by the cleaning liquid supply unit 307 can be efficiently replaced within a short time.

The nozzle 308A of the solvent supply unit 308 may be configured to discharge successively the volatile solvents of three or more different concentrations (e.g., 20%, 50% and 100%) in the order of the low, middle and high concentrations (i.e., in an ascending order).

The substrate processing devices 100 and 200 may be configured such that the nozzle 15A of the low-concentration solvent replacing unit (the organic solvent supply unit 15) successively discharges the volatile solvents of low and middle concentrations (i.e., two different concentrations), and the nozzle 34A of the high-concentration solvent replacing unit (the solvent supply unit 34) or the nozzle 214A of the high-concentration solvent replacing unit (the solvent supply unit 214) successively discharges the volatile solvents of middle and high concentrations (i.e., two different concentrations).

Although the invention has been described in detail with reference to the drawings, the specific structure of the invention is not restricted to these embodiments, and the invention contains changes and variations of design within a scope not departing from the essence of the invention.

The operations of supplying the low-humidity gas by the gas atmosphere forming units 38, 216 and 236 are configured to start after the substrate W is positioned at the supply position, but may be configured to start the supply operation prior to such positioning.

For example, in each Embodiment, the heating of the substrate W by the drying units 36 and 234, and the heating unit 311 may be performed in a state where the pressure in the processing boxes 31, 231 and 301 are reduced. This lowers the boiling point of the volatile solvent such as IPA in the processing boxes 31,231,301, and causes boiling at a temperature lower than that in the atmospheric pressure so that the heat damage to the substrate can be reduced.

In each embodiment, the supply of the volatile solvent such as IPA from the organic solvent supply units 15 and 308 to the substrate W starts after the supply of the cleaning liquid to the substrate W stops. However, the supply of the volatile solvent may start while the supply of the cleaning liquid to the substrate W still continues in a final period of the cleaning with the cleaning liquid.

### [Industrial Applicability]

The invention reliably replaces the cleaning liquid on the substrate surface with the volatile solvent, and thereby can effectively prevent the pattern collapse at the time of substrate drying.

### [Explanations of letters of numerals]

- 10: cleaning chamber
- 15: organic solvent supply unit (low-concentration solvent replacing unit)
- 30: solvent replacing chamber
- 34: solvent supply unit (high-concentration solvent replacing unit)
- 36: drying unit
- 38: gas atmosphere forming unit
- 100: substrate processing device
- 200: substrate processing device
- 210: solvent replacing chamber
- 216: gas atmosphere forming unit
- 220: transfer unit
- 224: gas atmosphere forming unit
- 230: drying chamber
- 236: gas atmosphere forming unit
- 300: substrate processing chamber
- 308: solvent supply unit (solvent replacing unit)
- W: substrate

## Claims

1. A substrate processing device (100, 200) for supplying a cleaning liquid to a surface of a substrate (W), replacing the cleaning liquid with a volatile solvent, and heating the surface of the substrate (W) to remove the volatile solvent and to dry the surface of the substrate (W), comprising:
a solvent replacing unit (15, 34, 308) replacing the cleaning liquid with a volatile solvent of a low concentration, and thereafter performing replacement with a volatile solvent of a high concentration.

2. The substrate processing device according to claim 1, wherein
the solvent replacing unit (34, 308) is arranged in a single processing chamber (31, 301).

3. The substrate processing device according to claim 1, further comprising:
a plurality of solvent replacing units (15, 214) replacing the cleaning liquid with the low or high concentration volatile solvent each of which has different concentration, wherein the solvent replacing units (15, 214) are arranged in different processing chambers (10, 210), respectively.

4. The substrate processing device according to claim 3, wherein
a low-concentration solvent replacing unit (15) for replacing the cleaning liquid with the volatile solvent of the low concentration is arranged in a cleaning chamber (10) supplying the cleaning liquid and the low-concentration volatile solvent to the surface of the substrate (W), and
a high-concentration solvent replacing unit (214) for replacing the cleaning liquid with the high-concentration volatile solvent is arranged in a solvent replacing chamber (210) supplying the high-concentration volatile solvent to the surface of the substrate (W) supplied with the cleaning liquid and the low-concentration volatile solvent, and replacing the cleaning liquid and the low-concentration volatile solvent on the surface of the substrate (W) with the high-concentration volatile solvent.

5. A substrate processing method for supplying a cleaning liquid to a surface of a substrate (W), replacing the cleaning liquid with a volatile solvent, and heating the surface of the substrate (W) to remove the volatile solvent and to dry the surface of the substrate (W), comprising:
a solvent replacing step of replacing the cleaning liquid with a volatile solvent of a low concentration, and thereafter performing replacement with a volatile solvent of a high concentration.

6. The substrate processing method according to claim 5, wherein
the solvent replacing step is performed in a single processing chamber (31, 301).

7. The substrate processing method according to claim 5, further comprising:
a plurality of solvent replacing steps of replacing the cleaning liquid with the low or high concentration volatile solvent each of which has different concentration, wherein the solvent replacing steps are performed in different processing chambers (210, 220, 230), respectively.

8. The substrate processing method according to claim 7, wherein
a low-concentration solvent replacing step of replacing the cleaning liquid with the volatile solvent of the low concentration is performed in a cleaning chamber (10) supplying the cleaning liquid and the low-concentration volatile solvent to the surface of the substrate (W), and
a high-concentration solvent replacing step of replacing (W) the cleaning liquid with the high-concentration volatile solvent is performed in a solvent replacing chamber (210) supplying the high-concentration volatile solvent to the surface of the substrate (W) supplied with the cleaning liquid and the low-concentration volatile solvent, and replacing the cleaning liquid and the low-concentration volatile solvent on the surface of the substrate (W) with the high-concentration volatile solvent.
